# EUROPÄISCHE PATENTSCHRIFT

(11) **EP 3 589 773 B1**
(45) Veröffentlichungstag und Bekanntmachung des Hinweises auf die Patenterteilung: **05.04.2023**
(21) Anmeldenummer: 18706710.3
(22) Anmeldetag: 19.02.2018
(51) Int. Cl.: C22C 1/04, C22C 14/00, C22C 21/00, C22C 30/00, C23C 14/34, C23C 14/06, C22C 32/00

(54) **SPUTTERTARGET UND VERFAHREN ZUR HERSTELLUNG EINES SPUTTERTARGETS**
SPUTTER TARGET AND METHOD FOR PRODUCING A SPUTTER TARGET
CIBLE DE PULVÉRISATION ET PROCÉDÉ DE PRODUCTION D'UNE CIBLE DE PULVÉRISATION

(30) Priorität: 28.02.2017 AT 4617 U
(43) Veröffentlichungstag der Anmeldung: 08.01.2020
(73) Patentinhaber: PLANSEE COMPOSITE MATERIALS GMBH, 86983 Lechbruck am See (DE)
(72) Erfinder: POLCIK, Peter, 86983 Lechbruck am See (DE); KOLOZSVARI, Szilard, 86983 Lechbruck am See (DE); MAYRHOFER, Paul, 7311 Neckenmarkt (AT); RIEDL, Helmut, 3932 Kirchberg am Walde (AT)
(74) Vertreter: Ciesla, Bettina
(86) Internationale Anmeldenummer: PCT/EP2018/054041
(87) Internationale Veröffentlichungsnummer: WO 2018/158101

(56) Entgegenhaltungen:
- CN-A- 104 480 444
- JP-A- H08 151 269
- US-A1- 2008 253 925
- US-A1- 2009 229 976

## Beschreibung

Die vorliegende Erfindung betrifft ein Target für die Verwendung in einem physikalischen Dampfabscheidungsprozess mit den Merkmalen des Oberbegriffs des Anspruchs 1, ein Verfahren zur pulvermetallurgischen Herstellung eines Targets, welches für die Verwendung in einem physikalischen Dampfabscheidungsprozess bestimmt ist und die Verwendung eines solchen Targets in einem physikalischen Dampfabscheidungsprozess.

In der Technik werden in großem Umfang Verfahren der physikalischen Dampfabscheidung (auch Gasphasenabscheidung genannt, engl. *physical vapor deposition,* PVD) zur Herstellung verschiedenster Schichten eingesetzt. Aufgrund des breiten Anwendungsspektrums solcher Schichten müssen verschiedenartige Beschichtungsmaterialien abgeschieden werden können.

Bei der physikalischen Dampfabscheidung stehen verschiedene Verfahren zur Verfügung, wie z. B. Verdampfen, Kathodenzerstäubung (sputter deposition) oder Lichtbogenverdampfung (cathodic arc deposition bzw. Arc-Source-Verdampfungstechnik).

Ein Target ist für die Verwendung in einem PVD-Prozess zur Abscheidung von Schichten auf ein dafür vorgesehenes Substratmaterial geeignet. Im Sinne der Erfindung sind unter dem Begriff "Target" insbesondere Sputtertargets und Targets für Lichtbogenverdampfung (auch Arc-Kathoden genannt) zu verstehen.

Die Targets werden je nach Werkstoff durch unterschiedliche Technologien hergestellt. Dabei kann man grundsätzlich zwischen pulver- und schmelzmetallurgischen Verfahren unterscheiden. Bei den pulvermetallurgischen Verfahren gibt es viele unterschiedliche Möglichkeiten, die entsprechend der Zusammensetzung des Targets unter Berücksichtigung der Eigenschaften der integrierten Elemente gewählt werden müssen. Beispielhaft sind hier Pressen, Sintern, Heißisostatisches Pressen (HIP), Schmieden, Walzen, Heißpressen (HP) oder Spark Plasma Sintern (SPS) - auch in Kombination untereinander - zu nennen. Bei der Beschichtung werden die Targets (auch Beschichtungsquellen oder kurz Quellen genannt) durch das Plasma, den Lichtbogen und nicht zuletzt durch die Heizung in der Beschichtungskammer thermisch beaufschlagt. Um eine zu starke Erwärmung der Beschichtungsquellen zu vermeiden, werden diese von der Rückseite her gekühlt. Diese Kühlung kann entweder über eine direkte Wasserkühlung der Targetrückseite oder über eine indirekte Kühlung über eine starre Kupferrückplatte oder biegsame Kupfermembranen erfolgen.

Im Stand der Technik sind unterschiedlich zusammengesetzte Targets bekannt. So zeigt die JP3084402 AITi Targets mit einer Zusammensetzung von AlxTi1-x-y-zMyRz, wobei
- M für ein oder mehrere Elemente aus der Gruppe W und Mo steht
- R Seltenerdelemente aus der Gruppe Y, Ce, La und Mischmetalle bezeichnet
und 0.05 ≤ x ≤ 0.7, 0.02 ≤ y ≤ 0.25, und 0.0005 ≤ z ≤ 0.05 gilt.

Die CN104480444 beschreibt eine Target-Zusammensetzung mit Ti von 10 - 50 at%, AI von 40 - 90 at%, sowie Gehalten von Co, Cr, Ta, W, Nb, Mo, Zr, V, B, Si, Y, La, Se und Ce, mit Co 0.1 - 10 at%, Cr 0.1 - 20 at%, Ta 0.1 - 10 at%, W 0.1 - 10 at%, Nb 0.1 - 10 at%, Mo 0.1 - 10 at%, Zr 0.1 - 10 at%, V 0.1 - 10 at%, B 0.1 - 10 at%, Si 0.1 - 20 at%, Y 0.1 - 10 at%, La 0.01 - 5 at%, Ce 0.01 - 5 at%, Se 0.01 - 5at%.

Die JPH08151269A ist auf ein thermoelektrisches Material auf Basis von Eisen, einem Lanthanoid und Silizium gerichtet

Einer der wichtigsten Parameter für eine wirtschaftliche Nutzung der PVD Technologie ist die Beschichtungsrate, welche die Geschwindigkeit beschreibt, mit der das Schichtwachstum auf dem Substrat erfolgt. Die Beschichtungsrate ist in erster Näherung von folgenden Parametern abhängig:
- Art der PVD Technologie (z. B. Lichtbogenverdampfung, Sputtern, HIPIMS, ...)
- Leistung, die auf die Beschichtungsquelle aufgebracht wird
- Anzahl der Targets
- Größe der Beschichtungsanlage
- Abstand zwischen dem Target und dem Substrat
- Rotationsgeschwindigkeit des Substrats vor dem Target
- Substratvorspannung (Biasspannung)

Einen großen Einfluss auf die Beschichtungsrate hat auch die Zusammensetzung des Targets selbst.

Unterschiedliche Elemente haben bedingt durch ihre physikalischen Eigenschaften unterschiedliche Verdampfungsgeschwindigkeiten. Besonders wichtig sind hier die vorhandenen Bindungen, die Größe der Elemente (Atomradius und atomare Masse), sowie die Austrittsarbeit, die benötigt wird, um ein Elektron in den freien, ungebundenen Zustand überzuführen. Durch die vorhandenen Bindungen wird definiert, wieviel Aufprallenergie (besonders beim Sputtern) notwendig ist, um ein Atom oder Cluster von Atomen aus der Targetoberfläche in die Gasphase überzuführen. Bei den Stoßprozessen durch das Arbeitsgas (im Folgenden wird als Beispiel für das Arbeitsgas Ar genannt, dies soll keine Beschränkung darstellen) entstehen auch Sekundärelektronen, die wiederum dazu führen, dass mehr Ar-Ionen entstehen, die weitere Atome der Targets sputtern können. Die Effektivität dieser Sputter-Prozesse hängt sehr stark von der eingebrachten Energie und vor allem von der Energiedichte ab. Erst wenn diese hoch genug ist, kann das Target zerstäubt werden. Dabei steigt die Beschichtungsrate (auch Zerstäubungsrate, Sputterrate) sehr stark mit ansteigender Energiedichte an und erreicht erst bei sehr hohen Energiedichten eine Sättigung.

Die Energiedichte kann durch höhere Energien der auftreffenden Ar-Ionen erhöht werden oder durch andere Parameter der Beschichtungsanlagen (wie z. B. Magnetfelder, welche die Interaktionen der Sekundärelektronen mit dem Arbeitsgas und damit dessen Ionisierungsgrad erhöhen) beeinflusst werden. Vor allem durch eine höhere Energie der auftreffenden Ar-lonen steigt aber auch die thermische Belastung der Targets (nahezu 90 % der auftreffenden Energie der Ar-Ionen wird in Wärme umgewandelt und nur ein kleiner Prozentanteil kommt dem gewünschten Sputtern zugute). Im Wesentlichen sind dies alles prozessgesteuerte Parameter. Aufgabe der Erfindung ist die Bereitstellung eines Targets und eines Verfahren zur Herstellung von Targets, bei welchen eine erhöhte Verdampfungsgeschwindigkeit und damit eine erhöhte Beschichtungsrate vorliegen.

Diese Aufgabe wird durch ein Target mit den Merkmalen des Anspruchs 1, ein Verfahren mit den Merkmalen des Anspruchs 7 und eine Verwendung gemäß Anspruch 8 gelöst.

Der wesentliche Vorteil der Erfindung liegt in einer erhöhten Beschichtungsrate (und damit schnellerem Schichtwachstum), welches bereits durch verhältnismäßig geringe Dotierung der Targets mit den ausgewählten Elementen aus der Gruppe der Lanthanoide: La, Ce, Nd, Sm und Eu erzielt werden kann.

Die Erfindung beruht auf der Erkenntnis der Anmelderin, dass sich die Beschichtungsrate sehr wirkungsvoll durch Zugabe von Dotierungselementen beeinflussen lässt. Dies basiert im Wesentlichen auf zwei Effekten:
Zum einen helfen die ausgewählten Dotierungselemente aus der Gruppe der Lanthanoide: La, Ce, Nd, Sm und Eu, die vorhandene Energie der auftreffenden Ar-lonen effektiver bezüglich der räumlichen Ausdehnung des Wechselwirkungsbereiches, zu nutzen. Die ausgewählten Dotierungselemente wirken durch deren Größe und Masse wie atomare "Rammböcke" (wenn diese entsprechend homogen im Target verteilt sind, wie eben bei pulvermetallurgisch hergestellten Targets der Fall), welche die vorhandene Stoßenergie bzw. den Impuls auf einen kleineren Wechselwirkungsbereich an der Targetoberfläche konzentrieren. Somit konzentriert sich die übertragene kinetische Energie auf weniger Atomlagen und es kann die gesamte Energie der auftreffenden Ar-lonen auf einen kleineren Bereich konzentriert werden. Damit steigt die Sputterrate bei gleichbleibender Energie der auftreffenden Ar-Ionen und es kommt zu einem effizienteren Sputterprozess. Damit einher geht auch eine Erhöhung der Sekundärelektronenemission was wiederum zu einem höheren Ionisierungsgrad des Arbeitsgases führt.

Zum anderen kann durch die ausgewählten Dotierungselemente aus der Gruppe der Lanthanoide: La, Ce, Nd, Sm und Eu, welche eine besonders geringe Elektronen-Austrittsarbeit aufweisen, auch die Sekundärelektronenemission erhöht werden. Eine geringere Elektronen-Austrittsarbeit bedeutet eine erhöhte Anzahl an Sekundärelektronen und damit eine erhöhte Entstehungswahrscheinlichkeit von Ionen des Arbeitsgases, welche wiederum mehr Targetatome herausschlagen können.

Bei der Erfindung kommt es zu einer Überlagerung beider Effekte, was die Sputterausbeute deutlich erhöht.

Ein weiterer positiver Effekt in reaktiven Sputterprozessen ist, dass durch die erhöhte Energiedichte (in den stärker konzentrierten oberflächennahen Wechselwirkungsbereichen des Targets durch die entsprechenden Elemente) die Vergiftung der Targetoberfläche schwieriger ist. Die Bildung von schlechter elektrisch leitfähigen Reaktionsprodukten des Targets mit dem Reaktivgas (z.B. N2) und deren Verbleib auf der Targetoberfläche (der zur bekannten Vergiftung der Targets führt) wird erschwert. Wenn sich derartige Produkte bilden, werden diese umgehend durch die erhöhte Anzahl an vorhandenen Ar-Ionen auch wieder abgetragen, und somit verbleibt das Target länger (auch bei höheren N2-Anteilen der Atmosphäre) im gewünschten metallischen Sputter-Mode.

Bei Arc-Evaporation Prozessen liegt der positive Effekt der Erfindung vor allem bei der erhöhten Elektronendichte an der Targetoberfläche, die wiederum die Arc-Events erhöht und damit die Verdampfungsrate.

Die ausgewählten Elemente aus der Gruppe der Lanthanoide: La, Ce, Nd, Sm und Eu haben zudem einen positiven Einfluss auf die Schichteigenschaften im Sinne der erzielbaren Härte oder Verschleißbeständigkeit.

Die Dotierungselemente werden in Form von keramischen Verbindungen oder, gemäß einer nicht erfindungsgemäßen Variante, alternativ in Form von Aluminium-Legierungen in die Targets eingebracht um niedrige Sauerstoffgehalte im Target gewährleisten zu können:
Die hier aufgelisteten Elemente haben eine hohe chemische Affinität zum Sauerstoff und oxidieren deshalb in reiner metallischen bzw. unlegierten Form sehr schnell. Würden die Dotierungselemente in Form von Oxiden vorliegen, so wären diese elektrisch nicht leitfähig und somit sehr schwierig im Abscheideprozess in die Dampfphase zu überleiten. In Form von keramischen Verbindungen wie Boriden, Karbiden, Nitriden und Siliziden oder Al Basis Legierungen sind diese Elemente weitestgehend vor der Oxidation geschützt.

Für die Zugabe von Cer eignet sich Cer-Disilizid besonders gut, da es im Temperaturbereich der Targetherstellung (bis 350°C) im Vergleich zum metallischen Cer viel beständiger gegen Oxidation ist. Außerdem weist Cer-Disilizid eine hohe Sprödigkeit auf, wodurch sich besonders feinkörnige Pulver über mechanische Zerkleinerung (Mahlen) darstellen lassen. Dies ist günstig bei der pulvermetallurgischen Fertigung der Targets. Mit feinkörnigen Pulvern erreicht man eine besonders homogene Verteilung des Dotierungselements.

Ein Sauerstoffgehalt im Target unterhalb von 5000 µg/g, bevorzugt unterhalb von 3000 µg/g zeigt sich zusätzlich als besonders günstig für die Schichteigenschaften. In Bezug auf die Eigenschaften der abgeschiedenen nanokristallinen PVD Schichten führen hohen Gehalte an Sauerstoff zur Schwächung der Festigkeit von Korngrenzen (Aufweichen der Interfaces), was wiederum zum Absenken der Härte und des E-Moduls der Schichten führt.

Bevorzugt ist vorgesehen, dass der Anteil an Elementen mit einer Austrittsarbeit von größer gleich 4,5 eV besonders klein ist, bevorzugt kleiner ist als 10 at%.

Damit kann eine unerwünschte Erhöhung der globalen (auf das gesamte Target bezogenen) Austrittsarbeit vermieden werden.

Ein großer Unterschied in den Austrittsarbeiten der Elemente aus denen das Target besteht kann auch dazu führen, dass die unterschiedlichen Körner aus denen das Gefüge des Targets besteht z. B. Ti, Al, oder CeAl, unterschiedlich stark beim PVD Prozess abgetragen werden und sich daher auch die Chemie der damit abgeschiedenen Schicht im Vergleich zur Zusammensetzung des Targets stark ändern würde. Dieser Effekt ist aus der Sicht der PVD Prozessstabilität unerwünscht.

Die Erfindung wird im Folgenden anhand der Figuren näher erläutert.

Dabei zeigt:
- Fig. 1: ein Diagramm der Beschichtungsrate (engl. *deposition rate*) als Funktion des Gehaltes an den Dotierungselementen Ce bzw. La
- Fig. 2: eine lichtmikroskopische Aufnahme eines TiAILaB6-Targets im Querschnitt
- Fig. 3: eine lichtmikroskopische Aufnahme eines TiAICe-Targets im Querschnitt

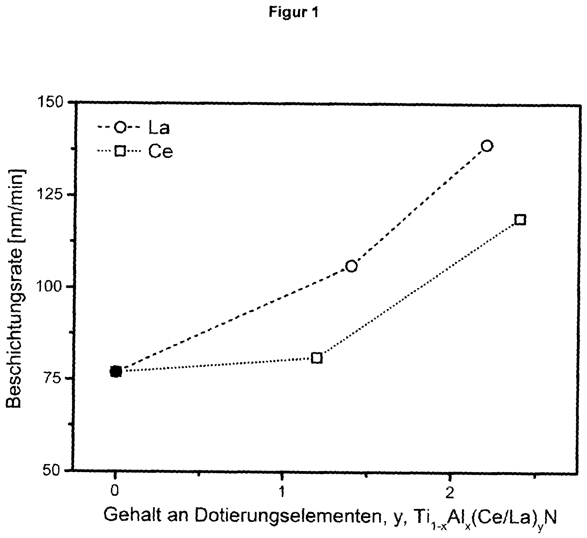

In Figur 1 ist die Beschichtungsrate in nm / min als Funktion des Gehaltes y [at.%] an den Dotierungselementen Ce bzw. La für ein TiAl, TiAICe, sowie TiAILaB6 Target dargestellt. Die Beschichtungsrate wurde mittels REM in Querschnittskonfiguration für Ti₁₋ₓAlₓN, Ti_{1-x-y}AlₓCe_{y}N, und Ti_{1-x-y}Alₓ(LaB₆)_{y}N Schichten ermittelt.

Die Beschichtungsrate für das undotierte TiAl Target entspricht dem Punkt mit 0 at. % Dotierungselement.

Die Gehalte y an den Dotierungselementen Ce bzw. La wurden in der abgeschiedenen Schicht ermittelt, die Summenformel für die Zusammensetzung der Schicht lautet Ti_{1-x-y}Alₓ(Ce/La)_{y}N.

Die Bestimmung der Konzentrationen der Elemente in der Schicht erfolgte durch EDX.

Durch gezieltes Legieren der Targets mit ca. 2 bis 2.5 at% (Ce oder LaB6) konnte eine Steigerung der Sputterrate von 50 bis 80 % für reaktives Sputtern (Gasgemisch: Ar/N2) erzielt werden.

Zur Erläuterung sei erwähnt, dass im Target das Lanthan als LaB6 vorliegt, in der daraus abgeschiedenen Schicht jedoch als elementares Lanthan - bevorzugt auf Gitterplätzen von Ti bzw. AI - vorliegt.

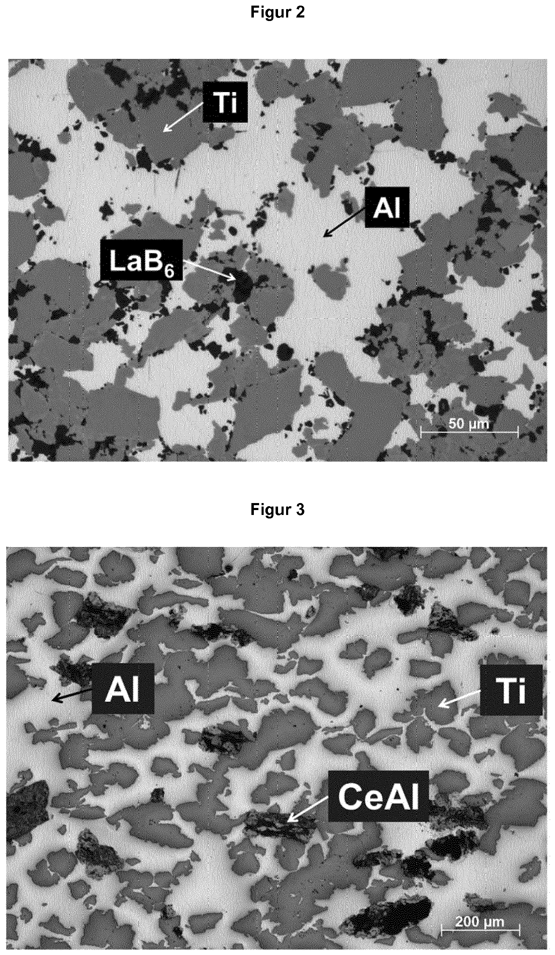

Figur 2 zeigt eine lichtmikroskopische Aufnahme eines TiAILaB6-Targets im Querschnitt. Wie im Bild gekennzeichnet, bestehen die hellen Bereiche aus Aluminium, die grauen Bereiche aus Titan und die schwarzen Bereiche aus LaB6 Pulverpartikeln.

Figur 3 zeigt eine lichtmikroskopische Aufnahme eines TiAlCe-Targets im Querschnitt. Wie im Bild gekennzeichnet, bestehen die hellen Bereiche aus Aluminium, die grauen Bereiche aus Titan Pulverpartikeln und die feinkörnigen dunkelgrauen Agglomerate aus einer CeAI-Legierung. Die schwarzen Bereiche im Gefüge entsprechen präparationsbedingten Kavitäten (Ausbrüche beim Schleifen der Probe).

### HERSTELLUNGSBEISPIELE

### Beispiel 1

Für die pulvermetallurgische Fertigung von Targets mit der nominellen Zusammensetzung von Ti/AI/LaB6 49,0/49,0/2,0 mol% wurde ein Pulveransatz von 800 g aus 460,4 g Ti Pulver, 259,5 g AI Pulver und 80,0 g LaB6 Pulver gemischt. Diese Einwaagen entsprechen der Zusammensetzung Ti/AI/LaB6 57,6/32,45/10,0 wt%. Bezogen auf die Elemente entspricht diese Zusammensetzung Ti/Al/La/B 43,8/43,8/1,8/10,6 at%.

Der Pulveransatz ist anschließend bei Raumtemperatur zu einem Pressling und anschließend zu einem Rohling bei 350°C geschmiedet worden. Aus dem Rohling ist abschließend ein Target mit den Abmessungen von Ø 75 x 6 mm durch mechanische Zerspanung gefertigt worden. Die Beschaffenheit solch eines Materials wird in Figur 2 gezeigt, an Hand einer lichtmikroskopischen Aufnahme an einem Querschnitt des Materials. Die so produzierten Targets, Scheiben mit den Dimensionen Ø 75 x 6 mm, sind anschließend auf Kupferkathoden einer Laborbeschichtungsanlage (adaptierte Leybold Heraeus Z400) mittels Indium gebondet und in Anlage eingebaut worden. In einem PVD Prozess wurden die Targets bei einem Gesamtdruck, p_{gesamt}, von 0.35 Pa in einer Gasmischung aus Ar und N₂ (20% N₂ Anteil) zerstäubt. Die Targets wurden mit einer Leistungsdichte von 9.0 W/cm² eine Dauer von 35 min betrieben. Die dadurch entstandenen Schichten wurden auf einkristalline Si Plättchen (100-Orientierung, 20x7x0.38 mm³) sowie metallographisch polierten Austenit-Plättchen (20x7x0.8 mm³) abgeschieden. Um eine ausreichende Haftung der Schichten gewährleisten zu können, wurden die Substratmaterialien in Aceton und Ethanol gereinigt, bevor sie in der Beschichtungsanlage thermisch bei 430±20 °C geätzt wurden. Anschließend an diesen thermischen Ätzvorgang wurde auch noch ein Plasmaätzen in einer reinen Ar-Atmosphäre bei einem Gesamtdruck von 6 Pa durchgeführt (Dauer 10 min). Während des Beschichtungsprozesses betrug die Substrattemperatur 430±20 °C, das Bias-Potential betrug -50 V. Die auf diese Weise abgeschiedenen Schichten weisen eine sehr dichte Morphologie sowie kubisch-flächenzentrierte Kristallstruktur auf, welche mittels Rasterelektronenmikroskopie (REM) und Röntgendiffraktometrie (XRD) untersucht wurde. Die chemische Zusammensetzung wurde mittels energiedispersiver Röntgenspektroskopie (EDX) im REM bestimmt. Um eine Verringerung des La-Gehalts in der abgeschiedenen Schicht zu erzielen wurden TiAl Stückchen (8 Stückchen mit Abmessungen von 4x4x4 mm³, mit chemischer Zusammensetzung von Ti/Al 50/50 at%) in den Racetrack gelegt. Trotz einer leichten Abdeckung des TiAILaB6 Targets durch die TiAl-Stückchen (weniger als 10 % des Racetracks) konnte eine klare Zunahme der Beschichtungsrate detektiert werden - siehe Figur 1. Die Dicke der Schichten betrug ca. 3650 bzw 4800 nm (die 3650 nm wurden erzielt für die Schicht mit ca. 1.5 at% La in der Schicht), für die jeweiligen La Gehalte (Figur 1). Die mechanischen Eigenschaften der Ti_{1-x-y}AlₓLa_{y}N Schichten wurden mittels Nanoindentation getestet und zeigten eine Steigerung im Vergleich zu rein Ti₁₋ₓAlₓN, welches bei denselben Bedingungen abgeschieden wurde.

### Beispiel 2 (nicht erfindungsgemäß)

Für die pulvermetallurgische Fertigung von Targets mit der nominellen Zusammensetzung von Ti/AI/Ce 49,0/49,0/2,0 at% wurde ein Pulveransatz von 800 g aus 475,3 g Ti Pulver, 260,2 g AI Pulver und 64,5 g Ce/AI 88/12 wt% Pulver gemischt. Diese Einwaagen entsprechen der Zusammensetzung Ti/Al/CeAl 59,4/32,5/8,1 wt%.

Der Pulveransatz ist anschließend bei Raumtemperatur zu einem Pressling und anschließend zu einem Rohling bei 350°C geschmiedet worden. Aus dem Rohling ist abschließend ein Target mit den Abmessungen von Ø 75 x 6 mm durch mechanische Zerspanung gefertigt worden. Die Beschaffenheit solch eines Materials wird im Figur 3 gezeigt, an Hand einer lichtmikroskopischen Aufnahme an einem Querschnitt des Materials. Die so produzierten Targets, mit den Dimensionen Ø 75 x 6 mm, sind anschließend auf Kupferkathoden einer Laborbeschichtungsanlage (adaptierte Leybold Heraeus Z400) mittels Indium gebondet und in Anlage eingebaut worden. In einem PVD Prozess wurden die Targets bei einem Gesamtdruck, p_{gesamt}, von 0.35 Pa in einer Gasmischung aus Ar und N₂ (20% N₂ Anteil) zerstäubt. Die Targets wurden mit einer Leistungsdichte von 9.0 W/cm² für eine Dauer von 45 min betrieben. Die dadurch entstandenen Schichten wurden auf einkristalline Si Plättchen (100-orientation, 20x7x0.38 mm³) sowie metallographisch polierten Austenit-Plättchen (20x7x0.8 mm³) abgeschieden. Um eine ausreichende Haftung der Schichten gewährleisten zu können, wurden die Substratmaterialien in Aceton und Ethanol gereinigt, bevor sie in der Beschichtungsanlage thermisch bei 430±20 °C geätzt wurden. Anschließend an diesen thermischen Ätzvorgang wurde auch noch ein Plasmaätzen in einer reinen Ar-Atmosphäre bei einem Gesamtdruck von 6 Pa durchgeführt (Dauer 10 min). Während des Beschichtungsprozesses betrug die Substrattemperatur 430±20 °C. Das Bias-Potential betrug -50 V. Die auf diese Weise abgeschiedenen Schichten weisen eine sehr dichte Morphologie sowie kubisch-flächenzentrierte Kristallstruktur auf, welche mittels Rasterelektronenmikroskopie (REM) und Röntgendiffraktometrie (XRD) untersucht wurde. Die chemische Zusammensetzung wurde mittels energiedispersiver Röntgenspektroskopie (EDX) im REM bestimmt. Die Schichten weisen Stärken von ca. 3600 bzw. 5000 nm auf. Diese zwei unterschiedlichen Schichtdicken wurden dadurch erlangt, dass für eine Verringerung des Ce-Gehaltes, 8 TiAl Stückchen (4x4x4 mm³, chemische Zusammensetzung von Ti/Al 50/50 at%) in den Racetrack gelegt wurden und so die Verstärkung der Beschichtungsrate gemindert wurde. Trotz einer leichten Abdeckung des TiAICe Targets durch die TiAI-Stückchen (weniger als 10 % des Racetracks) konnte eine Zunahme der Beschichtungsrate detektiert werden - siehe Figur 1. Die mechanischen Eigenschaften der Ti_{1-x-y}AlₓCe_{y}N Schichten wurden mittels Nanoindentation getestet und zeigten eine leichte Steigerung im Vergleich zu rein Ti₁₋ₓAlₓN, welches bei denselben Bedingungen abgeschieden wurde.

### Beispiel 3

Für die pulvermetallurgische Fertigung von Targets mit der nominellen Zusammensetzung von Ti/AI/CeSi2, 39,4/60,6/2,1 mol% wurde ein Pulveransatz von 800 g aus 383,2 g Ti Pulver, 332,0 g Al Pulver und 84,8 g CeSi2 Pulver gemischt. Diese Einwaagen entsprechen der Zusammensetzung Ti/AI/CeSi2 47,9/41,5/10,6 wt%. Bezogen auf die Elemente entspricht diese Zusammensetzung Ti/Al/Ce/Si 37,0/57,0/2,0/4,0 at%. Der Pulveransatz ist anschließend bei Raumtemperatur zu einem Pressling und anschließend zu einem Rohling bei 350°C geschmiedet worden. Aus dem Rohling ist abschließend ein Target mit den Abmessungen von ∅ 75 x 6 mm durch mechanische Zerspanung gefertigt worden.

## Patentansprüche

1. Target für die Verwendung in einem physikalischen Dampfabscheidungsprozess, mit einer Matrix aus einem Verbundwerkstoff ausgewählt aus der Gruppe bestehend aus aluminiumbasierter Werkstoff, titanbasierter Werkstoff sowie beliebige Kombinationen davon, wobei die Elemente der Matrix einen Anteil größer gleich 60 at% und kleiner gleich 99 at% des Targets bilden, wobei die Matrix mit Dotierungselementen dotiert ist, wobei die Dotierungselemente ausgewählt sind aus der Gruppe der Lanthanoide: La, Ce, Nd, Sm und Eu, **dadurch gekennzeichnet, dass** die Dotierungselemente als Bestandteile von keramischen Verbindungen in der Matrix eingebettet sind und dass die Dotierungselemente in Summe in einer Konzentration im Target in einem Bereich von größer gleich 1 at% und kleiner gleich 10 at%, vorzugsweise kleiner gleich 5 at% vorliegen

2. Target nach Anspruch 1, wobei die Matrix als aluminiumbasierter Werkstoff in einer Zusammensetzung von AlₓM₁₋ₓ vorliegt, wobei M eines oder mehrere Elemente aus der Gruppe von Ti, V, Cr, Zr, Nb, Mo, Ta, W, Si ist und x größer als 25 at.% ist.

3. Target nach wenigstens einem der vorangehenden Ansprüche, wobei der Sauerstoffgehalt im Target unterhalb von 5000 µg/g liegt, bevorzugt unterhalb von 3000 µg/g liegt.

4. Target nach wenigstens einem der vorangehenden Ansprüche, wobei der Anteil von Elementen mit einer Austrittsarbeit von größer gleich 4,5 eV im Target kleiner ist als 10 at%.

5. Target nach wenigstens einem der vorangehenden Ansprüche, wobei die keramischen Verbindungen ausgewählt sind aus der Gruppe von Boriden und/oder Karbiden und/oder Nitriden und/oder Siliziden.

6. Target nach wenigstens einem der vorangehenden Ansprüche, wobei das Dotierungselement Cer ist und als keramische Verbindung in Form von Cer-Disilizid vorliegt

7. Verfahren zur pulvermetallurgischen Herstellung eines Targets nach einem der vorangehenden Ansprüche, welches für die Verwendung in einem physikalischen Dampfabscheidungsprozess bestimmt ist, wobei zur Herstellung eines Pulveransatzes Dotierungselemente in ein metallisches Pulver eingebracht werden und der Pulveransatz verdichtet wird, und wobei das metallische Pulver ausgewählt ist aus der Gruppe bestehend aus aluminiumbasierten Werkstoff und/oder titanbasierten Werkstoff, **dadurch gekennzeichnet, dass** die Dotierungselemente als Bestandteile von keramischen Verbindungen in das metallische Pulver eingebracht werden und dass als Dotierungselemente Elemente aus der Gruppe der Lanthanoide: La, Ce, Nd, Sm und Eu verwendet werden, wobei die die Dotierungselemente enthaltenden keramischen Verbindungen in einer Konzentration von größer als 1 mol% bis kleiner gleich 25 mol%, vorzugsweise kleiner gleich 10 mol% jeweils bezogen auf den Pulveransatz, verwendet werden.

8. Verwendung eines Targets nach wenigstens einem der Ansprüche 1 - 6 oder hergestellt nach Anspruch 7 in einem physikalischen Dampfabscheidungsprozess.

## Claims

1. A target for use in a physical vapor deposition process, having a matrix composed of a composite material selected from the group consisting of aluminum-based material, titanium-based material and all combinations thereof, wherein the elements of the matrix form a proportion of greater than or equal to 60 at% and less than or equal to 99 at% of the target, wherein the matrix is doped with doping elements, wherein the doping elements are selected from the group consisting of the lanthanides: La, Ce, Nd, Sm and Eu, **characterized in that** the doping elements are embedded in the matrix as constituents of ceramic compounds and **in that** the doping elements are present in the target in a total concentration in a range from greater than or equal to 1 at% to less than or equal to 10 at%, preferably less than or equal to 5 at%.

2. The target as claimed in claim 1, wherein the matrix is present as aluminum-based material having a composition of AlₓM₁₋ₓ, where M is one or more elements from the group consisting of
Ti, V, Cr, Zr, Nb, Mo, Ta, W, Si and x is greater than 25 at%.

3. The target as claimed in at least one of the preceding claims, wherein the oxygen content in the target is less than 5000 µg/g, preferably less than 3000 µg/g.

4. The target as claimed in at least one of the preceding claims, wherein the proportion of elements having a work function of greater than or equal to 4.5 eV in the target is less than 10 at%.

5. The target as claimed in at least one of the preceding claims, wherein the ceramic compounds are selected from the group consisting of borides and/or carbides and/or nitrides and/or silicides.

6. The target as claimed in at least one of the preceding claims, wherein the doping element is cerium and is present as ceramic compound in the form of cerium disilicide.

7. A process for the powder-metallurgical production of a target according to at least one of the preceding claims, intended for use in a physical vapor deposition process, wherein doping elements are introduced into a metallic powder to produce a powder batch and the powder batch is compacted, and where the metallic powder is selected from the group consisting of aluminum-based material and/or titanium-based material, **characterized in that** the doping elements are introduced as constituents of ceramic compounds into the metallic powder and **in that** elements from the group consisting of the lanthanides: La, Ce, Nd, Sm and Eu are used as doping elements, wherein the ceramic compounds containing the doping elements are used in a concentration of greater than 1 mol% to less than or equal to 25 mol%, preferably less than or equal to 10 mol%, in each case based on the powder batch.

8. The use of a target as claimed in at least one of claims 1-6 or produced as per claim 7 in a physical vapor deposition process.

## Revendications

1. Cible pour l'utilisation dans un processus de dépôt physique en phase vapeur, comportant une matrice composée d'un matériau composite choisi dans le groupe constitué par un matériau à base d'aluminium, un matériau à base de titane ainsi que de quelconques combinaisons correspondantes, les éléments de la matrice formant une proportion supérieure ou égale à 60 % at et inférieure ou égale à 99 % at de la cible, la matrice étant dopée avec des éléments de dopage, les éléments de dopage étant choisis dans le groupe des lanthanoïdes : La, Ce, Nd, Sm et Eu, **caractérisée en ce que** les éléments de dopage sont incorporés en tant qu'ingrédients de composés céramiques dans la matrice et **en ce que** les éléments de dopage sont présents au total en une concentration dans la cible dans une plage de supérieur ou égal à 1 % at et inférieur ou égal à 10 % at, de préférence inférieur ou égal à 5 % at.

2. Cible selon la revendication 1, la matrice étant présente en tant que matériau à base d'aluminium dans une composition de AlₓM₁₋ₓ, M étant un ou plusieurs éléments du groupe de Ti, V, Cr, Zr, Nb, Mo, Ta, W, Si et x étant supérieur à 25 % at.

3. Cible selon au moins l'une quelconque des revendications précédentes, la teneur en oxygène dans la cible se situant en dessous de 5 000 µg/g, préférablement en dessous de 3 000 pg/g.

4. Cible selon au moins l'une quelconque des revendications précédentes, la proportion d'éléments dotés d'un travail d'extraction supérieur ou égal à 4,5 eV dans la cible étant inférieure à 10 % at.

5. Cible selon au moins l'une quelconque des revendications précédentes, les composés céramiques étant choisis dans le groupe des borures et/ou des carbures et/ou des nitrures et/ou des siliciures.

6. Cible selon au moins l'une quelconque des revendications précédentes, l'élément de dopage étant le cérium et étant présent en tant que composé céramique sous forme de disiliciure de cérium.

7. Procédé de préparation par métallurgie des poudres d'une cible selon l'une quelconque des revendications précédentes, qui est destinée à l'utilisation dans un processus de dépôt physique en phase vapeur, dans lequel, pour la préparation d'un lot de poudres, des éléments de dopage sont introduits dans une poudre métallique et le lot de poudres est densifié, et la poudre métallique étant choisie dans le groupe constitué par un matériau à base d'aluminium et/ou un matériau à base de titane, **caractérisé en ce que** les éléments de dopage sont introduits en tant qu'ingrédients de composés céramiques dans la poudre métallique et **en ce que** des éléments du groupe des lanthanoïdes : La, Ce, Nd, Sm et Eu sont utilisés en tant qu'éléments de dopage, les composés céramiques contenant les éléments de dopage étant utilisés en une concentration supérieure à 1 % en moles jusqu'à inférieure ou égale à 25 % en moles, de préférence inférieure ou égale à 10 % en moles à chaque fois par rapport au lot de poudres.

8. Utilisation d'une cible selon au moins l'une quelconque des revendications 1 à 6 ou préparée selon la revendication 7 dans un processus de dépôt physique en phase vapeur.
